# EUROPÄISCHE PATENTSCHRIFT

(11) **EP 2 834 859 B1**
(45) Veröffentlichungstag und Bekanntmachung des Hinweises auf die Patenterteilung: **23.03.2016**
(21) Anmeldenummer: 13713148.8
(22) Anmeldetag: 26.03.2013
(51) Int. Cl.: H01L 35/32, H01L 35/34

(54) **PULVERMETALLURGISCHE HERSTELLUNG EINES THERMOELEKTRISCHEN BAUELEMENTS**
POWDER METALLURGICAL PRODUCTION OF A THERMOELECTRIC COMPONENT
PROCÉDÉ DU DOMAINE DE LA MÉTALLURGIE DES POUDRES POUR FABRIQUER UN COMPOSANT THERMOÉLECTRIQUE

(30) Priorität: 29.03.2012 DE 102012205087
(43) Veröffentlichungstag der Anmeldung: 11.02.2015
(73) Patentinhaber: Evonik Degussa GmbH, 45128 Essen (DE)
(72) Erfinder: STENNER, Patrik, 63452 Hanau (DE); GIESSELER, Mareike, 63456 Hanau (DE); SCHULTZ, Thorsten, 64739 Hassenroth (DE); HOCH, Sascha, 44797 Bochum (DE); BUSSE, Jens, 44879 Bochum (DE); KRÄMER, Ann-Kathrin, 63452 Hanau (DE); SCHÜTTE, Rüdiger, 63755 Alzenau-Hörstein (DE)
(86) Internationale Anmeldenummer: PCT/EP2013/056327
(87) Internationale Veröffentlichungsnummer: WO 2013/144106

(56) Entgegenhaltungen:
- EP-A1- 1 928 035
- EP-A1- 2 136 416
- WO-A1-99/65086
- JP-A- 2010 157 645
- US-A- 6 127 619

## Beschreibung

Die Erfindung betrifft ein Verfahren zur Herstellung eines thermoelektrischen Bauelements oder zumindest eines Halbzeugs desselben, bei welchem zumindest ein thermoelektrisches Aktivmaterial in trockener Pulverform in zumindest einen Teil der Löcher einer perforierten Matrize eingebracht wird.

Ein thermoelektrisches Bauelement ist ein Energiewandler, welcher thermische Energie unter Ausnutzung des von Peltier und Seebeck beschriebenen thermoelektrischen Effekts in elektrische Energie umsetzt. Da der thermoelektrische Effekt reversibel ist, kann jedes thermoelektrisches Bauelement auch zur Umsetzung von elektrischer Energie in thermische Energie genutzt werden: so genannte Pelier-Elemente dienen unter elektrischer Leistungsaufnahme zum Kühlen bzw. Wärmen von Objekten. Peltier-Elemente verstehen sich daher auch als thermoelektrische Bauelemente im Sinne der Erfindung. Thermoelektrische Bauelemente, die zur Umwandlung von thermischer Energie in elektrische Energie dienen, werden oft als thermoelektrische Generatoren (TEG) bezeichnet.

Beispiele und Einführungen zu themoelektrischen Bauelementen finden sich unter:
- Thermoelectrics Goes Automotive, D. Jänsch (ed.), expert verlag GmbH, 2011, ISBN 978-3-8169-3064-8;
- JP2006032850A;
- EP0773592A2;
- US6872879B1;
- US20050112872A1;
- JP2004265988A

Technisch ausgeführte thermoelektrische Bauelemente umfassen mindestens ein aus zwei Thermoschenkeln gebildetes Thermopaar aus thermoelektrisch aktivem Material und ein das Thermopaar tragendes und/oder umschließendes und elektrisch nach außen hin isolierendes Substrat.

Im Stand der Technik ist eine Vielzahl von thermoelektrisch aktiven Materialien beschrieben. Für den kommerziellen Einsatz eignen sich beispielsweise Legierungen aus der Klasse der halbleitenden Wismuthtelluride (insbesondere mit zusätzlichen Anteilen von Selen und/oder Antimon) aus welchen sich - einerseits p-leitend und andererseits n-leitend dotiert - ein Thermopaar aufbauen lässt.

Weitere thermoelektrisch aktive Stoffklassen sind: Halb-Heusler-Materialien, verschiedene Silizide (insbesondere Magnesium, Eisen), verschiedene Telluride (Blei, Zinn, Lanthan, Antimon, Silber), verschiedene Antimonide (Zink,Cer, Eisen, Ytterbium, Mangan, Cobalt, Wismut; Teilweise auch als Zintl-Phasen bezeichnet), TAGS, Siliziumgermanide, Clathrate (insbes. auf Germanium-Basis). Neben diesen Halbleitermaterialien lassen sich thermoelektrische Bauelemente auch aus Kombinationen der meisten gewöhnlichen Metalle herstellen, wie dies z.B. bei handelsüblichen Thermoelementen zur Temperaturmessung der Fall ist, z.B. Ni-CrNi. Jedoch sind die so erzielbaren sog. Gütezahlen (thermoelektrische "Wirkungsgrade") deutlich geringer als bei den genannten Halbleitermaterialien.

Konventionelle thermoelektrische Bauelemente bestehen aus massiven Würfeln aus thermoelektrisch aktiven Halbleitern sowie harten keramischen Umhüllungen. Soweit massive Würfel eingesetzt werden, werden diese aus massiven Ingots herausgesägt. Des Weiteren ist es bekannt, thermoelektrisch aktives Material pulvermetallurgisch zu verarbeiten, um in einem Sinterschritt wieder möglichst dichte, hohlraumarme Blöcke (Schenkel) zu erhalten.

Nach diesem Stand der Technik ist es bekannt, das pulverförmig vorliegende Aktivmaterial durch eine perforierte Matrize hindurchzupressen, so dass tablettenförmige Grünlinge anfallen. Die Matrize ist dabei ein festes Werkzeug der Tablettiervorrichtung. Die durch die Matrize gepressten, thermoelektrischen Grünlinge werden sodann gesintert, unter Zuhilfenahme gelochter Raster geeignet angeordnet, miteinander über Lötbrücken elektrisch verbunden, das Raster wird wieder entfernt, verbleibende Kontaktbrücken werden aufgebracht, und das so erhaltene Halbzeug des thermoelektrischen Bauelements wird abschließend durch zwei Deckplatten aus Keramikwerkstoffen und gegebenenfalls seitlichen Abschluss (z.B. durch Silikondichtungsmassen) zum einsatzfähigen Modul komplettiert.

Aus der WO 2008061823 A1 ist es bekannt, ein Halbzeug für ein thermoelektrisches Bauelement herzustellen, indem auf bzw. in ein flächiges poröses Substrat thermoelektrisches Material als Pulver, Lösung oder über die Gasphase eingebracht wird.

EP 2 136 416 A1 offenbart ein Verfahren zur Herstellung eines thermoelektrischen Bauelements bei welchem zumindest ein thermoelektrisches Aktivmaterial in pastöser Form in Löchern einer perforierten Matrize eingebracht wird, dass das Aktivmaterial in den Löchern verbleibt und dass die mit Aktivmaterial gefüllte Matrize zu einem Bestandteil des herstellten thermoelektrischen Bauelements wird.

US 6127619 beschreibt ebenfalls die Herstellung von TEG mit Hilfe pastös aufgearbeiteter Aktivmaterialien.

WO 99/65086A1 offenbart, dass das Aktivmaterial eines thermoelektrischen Bauelements nicht nur als Paste, sondern auch als "compressed powder mixture" verarbeitet werden kann. Diese Schrift empfiehlt, das Pulver in einer gesonderten Form zu verarbeiten.

Auch die EP1928035A1 befasst sich mit der Verarbeitung thermoelektrische Aktivmaterialien in trockener Pulverform. Dabei wird das Aktivmaterial in eine Graphitform gefüllt und darin gesintert. Die Tatsache, dass der Sinterkörper später kleingeschnitten und poliert wird lässt darauf schließen, dass der Thermoschenkel aus der Graphitform entnommen oder die Form zerstört wird.

In Lichte dieses Standes der Technik liegt der vorliegenden Erfindung die Aufgabe zu Grunde, ein Verfahren zur Herstellung eines thermoelektrischen Bauelements bzw. eines entsprechenden Halbzeugs anzugeben, welches sich besonders wirtschaftlich durchführen lässt, und welches hinsichtlich der Freiheitsgrade seiner geometrischen Gestaltparameter besonders flexibel ist.

Gelöst wird die Aufgabe dadurch, dass das Aktivmaterial in den Löchern der Matrize verbleibt und dass die mit Aktivmaterial gefüllte Matrize zu einem Bestandteil des hergestellten thermoelektrischen Bauelements wird.

Gegenstand der Erfindung ist mithin ein Verfahren zur Herstellung eines thermoelektrischen Bauelements oder zumindest eines Halbzeugs desselben, bei welchem zumindest ein thermoelektrisches Aktivmaterial in trockener Pulverform in zumindest einen Teil der Löcher einer perforierten Matrize eingebracht wird, bei welchem das Aktivmaterial in den Löchern verbleibt und dass die mit Aktivmaterial gefüllte Matrize zu einem Bestandteil des hergestellten thermoelektrischen Bauelements wird.

Die vorliegende Erfindung beruht auf dem Gedanken, die im pulvermetallurgischen Herstellen von thermoelektrischen Bauelementen bekannte Matrize nicht bloß als Werkzeug zu betrachten, sondern das Pulver in einer Matrize zu verpressen, die später zugleich das thermoelektrisch inaktive Substrat des thermoelektrischen Bauelements darstellt und zugleich eine Passivierung, also den Schutz vor äußeren Einwirkungen des Aktivmaterials bewirkt. Dies setzt voraus, dass die Matrize aus einem Material mit einer minimalen elektrischen Leitfähigkeit (elektrischer Isolator) besteht. Darüber hinaus muss die Matrize eine für thermoelektrische Applikationen ausreichende thermische Beständigkeit aufweisen und möglichst preiswert verfügbar sein. Weiterhin ist es vorteilhaft, wenn die Matrize aus einem Material mit einer niedrigen thermischen Leitfähigkeit (thermischer Isolator) besteht, um zu gewährleisten, dass ein Maximum des durch das thermoelektrische Bauelement fließenden Gesamtwärmestroms durch die thermoelektrisch aktiven Schenkel fließt, wo sich daraus elektrische Leistung gewinnen lässt, und dementsprechend möglichst wenig des Gesamtwärmestromes ohne Nutzen an den thermoelektrisch aktiven Schenkeln vorbei durch das Matrizenmaterial (Substrat) fließt.

Die Matrize kann wahlweise aus dichtem oder porösem Material bestehen. Die Löcher der Perforation werden in geeigneter Weise als durchgehende Löcher ausgeführt, die in die Matrize z.B. mechanisch oder mittels einer Laserschneidtechnik eingebracht werden. Sofern die Perforation mechanisch hergestellt wird, bietet es sich an, dies auf derselben Maschine auszuführen, die auch den späteren Verpressvorgang vornimmt, insbesondere mit Hilfe eines schneidenden Lochwerkzeugs.

Für jedes Thermopaar sind je zwei unterschiedlich leitende thermoelektrische Aktivmaterialien notwendig, die elektrisch miteinander verbunden werden, wobei das erste Aktivmaterial z.B. p-leitend und das zweite Aktivmaterial n-leitend ist, oder umgekehrt. Unterschiedlich bedeutet hier, dass die beiden Aktivmaterien einen unterschiedlichen Seebeck-Koeffizienten aufweisen. P- und n-leitende Halbleiter sind als Aktivmaterialien besonders bevorzugt, da ihre Seebeck-Koeffizienten unterschiedliche Vorzeichen (negativ bei n-Leitern, positiv bei p-Leitern) aufweisen und daher der numerische Unterschied der Seebeck-Koeffizienten besonders groß ist. Dies erhöht die Effizienz des thermoelektrischen Bauelements.

Vorzugsweise werden nach dem erfindungsgemäßen Verfahren beide Aktivmaterialien trocken verpresst. Eine bevorzugte Weiterbildung der Erfindung sieht so vor, das in einem ersten Verfahrensabschnitt das erste thermoelektrische Aktivmaterial (z.B. p-leitend) in einem ersten Teil der Löcher eingepresst wird, und das in einem zweiten Verfahrensschritt das zweite thermoelektrische Aktivmaterial (beispielsweise n-leitend) in einen zweiten Teil der Löcher eingepresst wird. Im ersten Verfahrensabschnitt werden mithin die ersten Schenkel hergestellt und im zweiten Verfahrensabschnitt die zweiten Schenkel.

Grundsätzlich lässt sich nach dem erfindungsgemäßen Verfahren jedes thermoelektrische aktive Material einsetzen, welches sich pulvermetallurgisch verarbeiten lässt.

Vorzugsweise handelt es sich bei dem pulverförmigen Aktivmaterial um Wismuthtellurid, dessen mittels Laserbeugungsverfahren bestimmte Partikelgrößenverteilung eine mittlere Partikelgröße d₅₀ zwischen 1 und 100 µm, bevorzugt zwischen 2 und 10 µm und ganz besonders bevorzugt zwischen 3 und 5 µm aufweist. Pulver mit diesen Pulvereigenschaften verhalten sich nämlich noch nicht wie Fluide und setzen dementsprechend die Einpresskräfte nur unwesentlich in Querkräfte um, welche die Wandungen der Löcher belasten und die Matrize beschädigen könnten.

Die genannten Partikelgrößenverteilungen lassen sich mittels Laserbeugung einfach und eindeutig bestimmen. Ein geeignetes Gerät zur Bestimmung der Partikelgrößenverteilung ist unter der Typenbezeichnung LA-950 bei der Firma HORIBA erhältlich. Zur Messung der Partikelgrößenverteilung mittels einer HORIBA LA-950 wird das Pulver in demineralisiertem Wasser dispergiert. Um Sedimentation zu vermeiden, ist die maximale Kreislauf-Pumprate zu wählen.

Wie bereits ausgeführt, sollte die Matrix eines thermoelektrischen Bauelements nach Möglichkeit einen guten thermischen und elektrischen Isolator darstellen. Dementsprechend wird beim vorliegenden Verfahren eine Matrize aus einem nichtmetallischen Werkstoff eingesetzt. Hierzu werden vorzugsweise Hochleistungskunststoffe wie beispielsweise Polyetheretherketon (PEEK), Polytetrafluorethylen (PTFE), Polyphenylsulfon (PPSU), Polyphenylensulfid (PPS) oder Polyimiden (z.B. P84® von EVONIK Industries AG) eingesetzt.

Sofern diese organischen Werkstoffe für den beabsichtigten Einsatzzweck nicht geeignet sind, kommen Werkstoffkombinationen auf Basis von Kieselsäure oder anderen Metalloxiden als Grundstoff für die Matrize in Betracht. Geeignete Kieselsäuren sind unter den Handelsnamen Aerosil® bzw. Sipernat® bei der Evonik Industries AG erhältlich. Aus diesen pyrogenen bzw. gefällten Kieselsäuren lassen sich Platten pressen, die gelocht als Matrize für die Durchführung des vorliegenden Verfahrens geeignet sind. Ein Verfahren zur Herstellung von Isolatorplatten aus pyrogener Kieselsäure ist z.B. in EP119382A1 und US20110089363A1 beschrieben.

Weiterhin sind Verbundwerkstoffe aus anorganischen Rohstoffen und Bindemitteln als Matrizenmaterial einsetzbar, wie z.B. Verbundstoffe bestehend aus Glimmer, Perliten, Phlogopite oder Muscovite gebunden durch Silikone, Silikonharze (erhältlich unter den Markennamen Miglasil® und Pamitherm® bei Schweizer Firma von Roll AG) oder keramische Bindersysteme, insbesondere Zement (erhältlich unter dem Markennamen C-Therm® bei der Schweizer Firma von Roll AG). Derartige Platten lassen sich mittels eines schneidenden Lochwerkzeugs perforieren und als Matrize im Sinne der Erfindung verwenden.

Die Stärke der Matrize sollte 0.1 bis 10 mm, vorzugsweise 0.5 bis 5 mm, ganz besonders bevorzugt 1 bis 3 mm betragen. Die Stärke ist unabhängig vom Matrizenmaterial und richtet sich nach den notwendigen elektrischen Eigenschaften. Bevorzugt erstrecken sich die Löcher der Matrize im Wesentlichen parallel zur Flächennormalen der Matrize. Im einfachsten Fall ist die Matrize vollständig eben und weist mithin nur eine einzige Flächennormale auf. Falls die Matrize komplizierter geformt wie beispielsweise kreisförmig gebogen ist, versteht sich unter der Flächennormalen der Normalenvektor zur Oberfläche der Matrize im Zentrum des Loches. Aus der orthogonalen Ausrichtung der Löcher zur Oberfläche der Matrize folgt, dass sich die Schenkel der Thermopaare nicht in der Ebene der Matrize erstrecken, sondern senkrecht dazu. Auf diese Weise wurde die thermische Isolierfähigkeit des Matrizwerkstoffes zur Verbesserung der Ausbeute des Thermoelements nutzbar gemacht, da die für die Leistungsabgabe maßgebliche Temperaturdifferenz zwischen den beiden Enden des Thermopaares dank der geringen thermischen Leitfähigkeit der Matrize besser gehalten wird.

Die Löcher können einen kreisrunden Querschnitt haben. Gleichwohl können Sie einen elliptischen oder einen polygonalen, insbesondere einen hexagonalen Querschnitt aufweisen. Um eine einheitliche, zahlenmäßig bewertbare geometrische Beschreibung verschiedener Querschnittsformen vornehmen zu können, wird im Folgenden statt vom Durchmesser, der eine Kreisform voraussetzt, vom Äquivalentdurchmesser gesprochen. Dieser ist der Durchmesser eines Kreises, welcher die gleiche Fläche aufweist wie der jeweils betrachtete tatsächliche Querschnitt.

Der Äquivalentdurchmesser der Löcher ist im Hinblick auf die Stärke der Matrix so zu wählen, dass einerseits eine maximale Packungsdichte der Schenkel der Thermopaare erreicht wird und andererseits die mechanische Stabilität der Matrize während des Pressvorgangs und in der späteren Nutzung des Bauelementes nicht gefährdet wird. In Abhängigkeit von dem verwendeten Matrizen-Material beträgt das Verhältnis des Äquivalentdurchmessers der Löcher zur Stärke der Matrize 0.1 bis 10, bevorzugt 0.5 bis 5, und ganz besonders bevorzugt 1 bis 2.

Da die zu verarbeitenden thermoelektrischen Aktivmaterialien in Pulverform eine besonders große Oberfläche aufweisen, sind sie in hohem Maße oxidationsanfällig. Durch Oxidation des Aktivmaterials steigt dessen Innenwiderstand, was die Effizienz des thermoelektrischen Elements schmälert. Von daher sieht es die Erfindung bevorzugt vor, das Verfahren in inerter und/oder reduzierender Atmosphäre durchzuführen. Inerte Atmosphäre bedeutet in diesem Zusammenhang unter angemessenem Ausschluss von Sauerstoff, Wasser oder anderen auf die verwendeten Werkstoffe oxidierend wirkenden Medien, beispielsweise unter Schutzgas wie Argon oder Stickstoff. Eine reduzierende Atmosphäre kann unter besonders günstigen Bedingungen sogar geeignet sein, störende Oxidschichten von dem Aktivmaterial zu entfernen bzw. in die wirksame metallische Form umzuwandeln. Als reduzierende Atmosphäre kommen insbesondere Wasserstoff oder wasserstoffhaltige Gasmischungen in Betracht. Ganz besonders bevorzugt wird eine sowohl inerte, als auch reduzierend wirkende Atmosphäre gewählt. Hier bietet sich ein Gasgemisch aus Stickstoff und Wasserstoff an. Ein besonders geeignetes Gemisch enthaltend 95 bis 99.5 Vol.-% N₂ und 0.5 bis 5 Vol.-% H₂ ist als Formiergas bekannt.

Bevorzugt wird das Aktivmaterial auch unter inerter Atmosphäre (oder in wasserfreier Flüssigkeit dispergiert) gemahlen und bereitgestellt.

In einer bevorzugten Weiterbildung der Erfindung wird die Matrize während des Einpressens des Aktivmaterials von einer Bahn gestützt, welche zumindest die momentan mit Aktivmaterial zur verpressenden Löchern endseitig abdeckt. Die Bahn nimmt die beim Einpressen auftretenden Kräfte auf und verhindert durch das Abdecken der zu verpressenden Löcher ein Austreten des Pulvers aus der Matrize, da dieses erfindungsgemäß in der Matrize verbleiben soll.

Bevorzugt wird die Matrize während des Einpressens des Aktivmaterials von einem Niederhalter gegen die Bahn gedrückt, dergestalt, dass die Matrize zwischen Niederhalter und Bahn gehalten wird. Auf diese Weise wird die Matrize beidseitig zwischen Bahn und Niederhalter gespannt, was eine Zerstörung der Matrize beim Einpressen des Pulvers verhindert. Der Niederhalter muss bei dieser Ausführungsform der Erfindung mit einem Lochbild versehen sein, welches mit dem Lochbild der Matrize korrespondiert, um ein Einfüllen des Pulvers zu ermöglichen. Das Aktivmaterial wird vorzugsweise in einem ersten Schritt aus einem sich koaxial zu dem befüllenden Loch erstreckenden Rohr in das zu befüllende Loch eingefüllt und in einem zweiten Schritt wird das in das Loch eingefüllte Aktivmaterial mit einem sich koaxial zu dem befüllenden Loch erstreckenden Stempel verpresst.

Die Querschnittsfläche des Rohres bzw. die Querschnittsfläche des Stempels sollte dabei im Wesentlichen der Querschnittsfläche des Loches entsprechen. "Im Wesentlichen" bedeutet in diesem Zusammenhang +/- 10 % Abweichung. Wesentlich gleiche Querschnitte verhindern, das Aktivmaterial außerhalb des Loches auf die Matrix aufgegeben wird bzw. die Presskraft des Stempels nicht allein auf das Pulver, sondern auch auf das das Loch umgebende Matrixmaterial ausgeübt wird.

Das Aktivmaterial muss nicht rein zu einem Grünling des Thermoschenkels verpresst werden. Gegebenenfalls kann es zusammen mit zumindest einem pulverförmigen Additiv verpresst werden.

Erfindungsgemäß befasst sich das vorliegende Verfahren schwerpunktmäßig mit dem Anordnen des Pulvers in der Matrix. Um aus dem in dieser Weise hergestellten Halbzeug ein funktionierendes thermoelektrisches Bauelement herzustellen, ist es erforderlich, das in den Löchern verpresste Aktivmaterial (die Grünlinge) einem Sinterprozess zu unterwerfen, um es in den Löchern zu verfestigen und einen ausreichend niedrigen spezifischen elektrischen Widerstand zu erhalten.

Besonders bevorzugt erfolgt der Sinterprozess des in den Löchern verpressten Aktivmaterials vermittels Strom-Sinter-Methoden, insbesondere mittels so genanntem SPS - Spark Plasma Sintering, d.h. vermittels Durchleitung von elektrischem Strom und daraus folgender Aufheizung des Halbleitergefüges. Das Versintern erfolgt vorzugsweise in Kombination mit dem Verpressvorgang, indem der Stempel zugleich als Elektrode verwendet wird. Die Bahn stellt dabei die Gegenelektrode dar. Der Sintervorgang (d.h. der elektrische Stromfluss) kann dabei bereits während der Verdichtung einsetzen, nach erfolgter Verdichtung unmittelbar anschließen oder aber in der gleichen oder einer ähnlichen Anordnung unter gleichem oder anderem mechanischen Belastungsdruck zu einem späteren Zeitpunkt erfolgen.

Alternativ zur Sinterung durch elektrischen Strom kann die Sinterung nach dem Verpressvorgang thermisch, also in einem konventionellen Ofenprozess erfolgen.

Das in den Löchern versinterte Aktivmaterial ist zumindest auf einer Seite elektrisch untereinander in geeigneter Weise zu kontaktieren, beispielsweise durch Löten. Durch das Zusammenlöten der einzelnen versinterten Aktivmaterialien (Thermoschenkel) entstehen die thermoelektrisch aktiven Thermopaare. Darüber hinaus können eine Vielzahl von Thermopaaren innerhalb eines thermoelektrischen Bauelements parallel und/oder seriell verschaltet sein, um die Leistung zu erhöhen. Das Verschalten der Thermoschenkel bzw. -Paare erfolgt vorzugsweise mit bekannter Löttechnologie.

Allerdings ist beim Löten zu beachten, dass Bestandteile des Lotes (insbes. Zinn, Silber, Blei) signifikant in die Aktivmaterialien eindiffundieren können, was die Leistungsfähigkeit des thermoelektrischen Bauelementes nachhaltig beeinträchtigen kann. Um dies zu verhindern, ist üblicherweise zwischen Aktivmaterial und Lot eine so genannte Diffusionsbarriere vorzusehen. Als Diffusionsbarriere eignet sich insbesondere eine Schicht aus Nickel, Wolfram, Molybdän oder Kohlenstoffmodifikationen, allein oder Mischungen daraus. Statt eine solche Schicht in bekannter Weise aufzutragen (Sputtern, Chemical Vapour Deposition, Pulver-Plasmaspritzen) schlägt die Erfindung eine umformende Verarbeitung der Diffusionsbarriere vor: Dementsprechend wird auf die Matrize ein Gesenk und auf dieses wiederum eine Folie aus Barrierematerial, insbesondere aus Nickel, aufgelegt und mittels des Stempels an der Schneidkante des Gesenks eine Scheibe aus der Folie ausgestanzt und diese als Barriereschicht auf das Aktivmaterial aufgepresst.

Optional kann auf die Diffusionsbarriere noch eine Kontaktschicht beispielsweise aus Zinn aufgebracht werden, um bei anschließenden Lötprozessen eine bessere Anbindung an die Diffusionsbarriereschicht zu erreichen. Die Kontaktschicht kann mit denselben Technologien aufgebracht werden wie die Diffusionsbarriere.

Ein weiterer besonderer Vorteil dieser Erfindung liegt darin, dass durch die Verwendung des Matrixmaterials zwischen den thermoelektrischen Aktivmaterialien eine besonders gute thermische Isolation dieser "Toträume" ermöglicht wird, was die auszunutzenden Wärmeströme durch das Bauelement besonders wirksam in den thermoelektrisch aktiven Bereichen konzentriert, während sog. "thermische Kurzschlüsse" an den thermoelektrisch aktiven Schenkeln vorbei minimiert werden, was somit den Systemwirkungsgrad (die Energieausbeute bzw. -ausnutzung) maximiert. In einem konventionellen thermoelektrischen Bauelement befindet sich zwischen den thermoelektrisch aktiven Schenkeln Luft bei Normaldruck. Die Wärmeleitfähigkeit von Luft bei Normaldruck und Raumtemperatur beträgt unter Vernachlässigung von Konvektion bereits ca. 26 mW/(m*K). Bei den typischerweise in konventionellen Bauelementen vorliegenden Spaltweiten im Millimeterbereich kommen noch signifikante Beiträge durch konvektiven Wärmetransport sowie Strahlung hinzu, so dass deutlich höhere effektive Wärmeleitfähigkeiten resultieren können, insbesondere bei höheren Heißseitentemperaturen. Erfindungsgemäß eingesetzt Substrate auf Kieselsäurebasis weisen dagegen typischerweise unter obigen Bedingungen effektive Gesamt-Wärmeleitfähigkeiten von deutlich unter 25 mW/(m*K) auf, Werte von 18-22 mW/(m*K) sind in vielen Fällen darstellbar. Durch die besonders wirksame Verringerung des Strahlungswärmeaustauschs zwischen Heiß- und Kaltseite wächst der Vorteil gegenüber konventionellen Bauelementen mit steigender Heißseitentemperatur überproportional weiter an. Somit sind erfindungsgemäße thermoelektrische Bauelemente besonders überlegen bei höheren Einsatztemperaturen.

### Figurenbeschreibung

Die vorliegende Erfindung soll nun anhand von Ausführungsbeispielen näher erläutert werden. Hierfür zeigen schematisch:
- Figur 1:: Übersicht Verfahrenablauf;
- Figur 2:: Draufsicht Matrize mit zwei Schnitten;
- Figuren 3 bis 5:: Lochen der Platte;
- Figuren 6 bis 9:: Einfüllen des Aktivmaterials in die eingespannte Matrize;
- Figuren 10 bis 12:: Verpressen und Sintern des Pulvers;
- Figur 13:: Entfernen des Stempels;
- Figur 14:: Draufsicht Halbzeug mit zwei Schnitten.

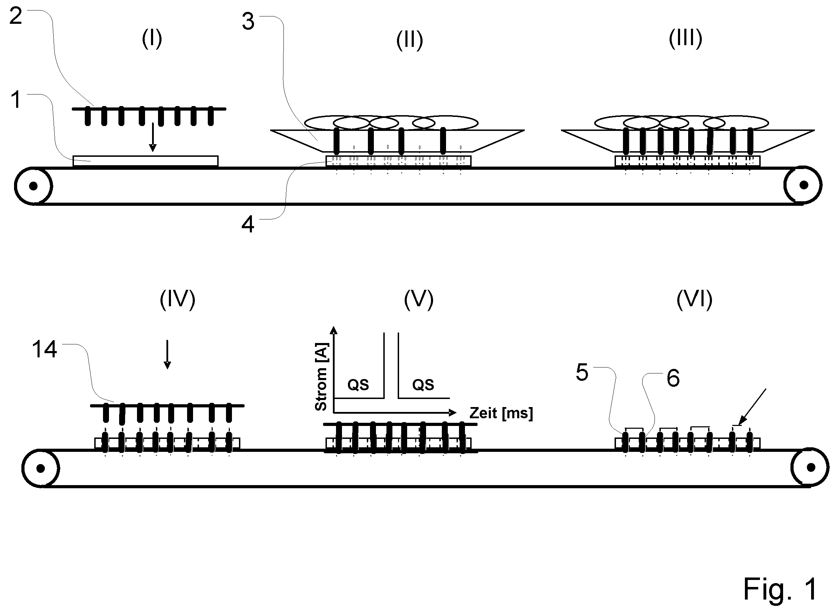

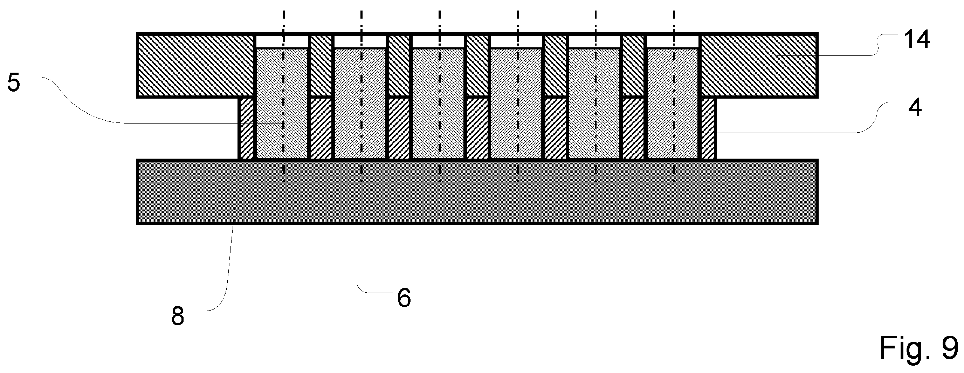

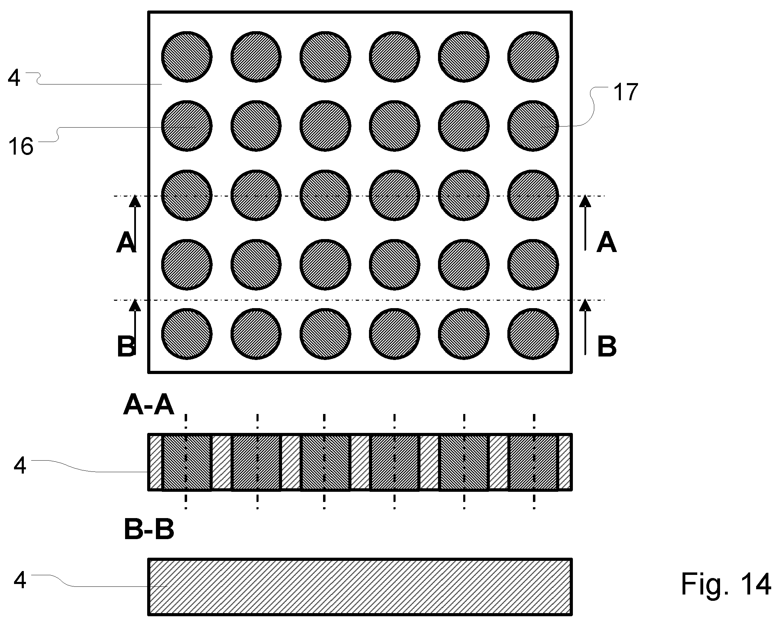

Figur 1 zeigt den erfindungsgemäßen Herstellungsprozess für ein thermoelektrisches Bauelement bzw. eines Halbzeugs desselben schematisch. In einem ersten Arbeitsschritt (I) wird eine noch unperforierte Platte 1 mechanisch durch einen schneidendes Lochwerkzeug 2 mehrfach gelocht, so dass eine gelochte Matrize entsteht. Sodann wird in einem ersten Befüllschritt (II) eine Maske 3 über der nunmehr gelochte Matrize 4 angeordnet und mit einem ersten thermoelektrisch aktiven Material (z.B. p-leitend) in trockener Pulverform befüllt. Befüllt werden in diesem Schritt nur die Hälfte der Löcher der gelochten Matrize 4. In einem zweiten Befüllschritt (III) werden dann die übrigen Löcher mit der zweiten Sorte Aktivmaterial befüllt wie zuvor. Die Befüllung erfolgt in einer Weise, dass die beiden thermoelektrisch aktiven Materialien alternierend nebeneinander angeordnet sind (siehe auch Figuren 9 und 14).

In einem nächsten Arbeitsschritt (IV) werden die in der Matrize 4 befindlichen trockenen Pulver zu Grünlingen verpresst. Im nächsten Arbeitsschritt (V) wird das verpresste Pulver, also die in den Löchern befindlichen Grünlinge der späteren Thermoschenkel, gesintert, indem vorzugsweise die einzelnen Pulverkompaktate mit einem großen elektrischen Strom (Gleichstrom oder Überlagerung von Gleichstrom mit Wechselstrom) beaufschlagt werden, welcher auf Grund des ohmschen Widerstands Wärme in dem Pulver induziert und dieses zum Versintern veranlasst. Wenn der Stempel als Elektrode verwendet wird, können die Arbeitsschritte (IV) und (V) rationell vereinigt werden. Gegebenenfalls kann zusätzlich zur Erwärmung des Pulverkompaktates ein Pressdruck über die Presseinrichtung aufgegeben werden, was eine Versinterung der Einzelpartikel zusätzlich befördert bzw. den Vorgang bei niedrigeren Temperaturen und/oder geringeren Haltezeiten durchführbar machen kann. Zwischen den einzelnen Versinterungsschritten kann erforderlichenfalls eine Qualitätssicherung durchgeführt werden. Auf diese Weise erhält man eine Matrize 4 mit alternierend darin angeordneten, versinterten Thermoschenkeln 5, 6. Um aus diesem Halbzeug ein thermoelektrisch aktives Bauelement herzustellen, bedarf es noch einer elektrischen Kontaktierung der einzelnen Thermoschenkel in an sich bekannter Weise durch bspw. Löten (Arbeitsschritt VI).

Gegebenenfalls ist vor dem Löten noch eine Diffusionsbarriere auf das Aktivmaterial aufzutragen, um zu verhindern, dass das Lot in das Aktivmaterial eindiffundiert. Es bietet sich an, die Diffusionsbarriere aus einer Folie aus Barrierematerial herzustellen, indem die Folie auf ein auf die Matrize aufgelegtes Gesenk aufgelegt und mittels des Stempels als Scheibe an der Schneidkante des Gesenks ausgestanzt und mit dem Pulver verpresst wird. Optional kann zwischen Diffusionsbarriere und Lot noch eine Kontaktschicht beispielsweise aus Zinn aufgebracht werden, um den Anschluss zwischen Lot und Diffusionsbarriere zu verbessern.

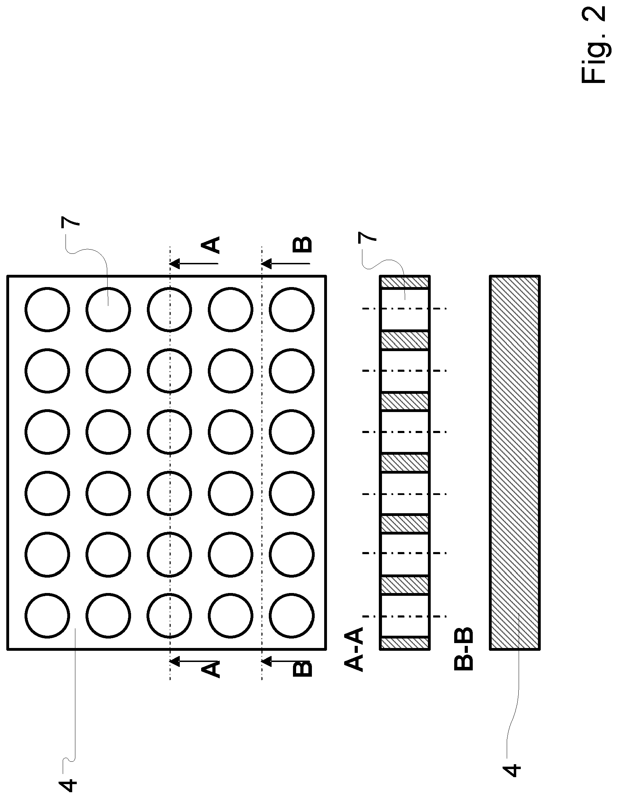

Figur 2 zeigt oben die Draufsicht auf eine flache, ebene Matrize 4 mit einer Vielzahl von Löchern 7, sowie darunter zwei Querschnitte durch diese Matrize an verschiedenen Positionen. Die Löcher 7 werden im Folgenden alternierend mit zwei unterschiedlichen Aktivmaterialien befüllt, welche später zu den Thermoschenkeln werden. Die Löcher 7 haben denselben Durchmesser und eine kreisrunde Form. Die Mittelpunkte der Löcher 7 liegen auf einem regelmäßigen, quadratischen Raster. Es ist denkbar, unrunde, insbesondere polygonale oder elliptische Löcher vorzusehen. Auch können die Mittelpunkte auf einem unregelmäßigen Raster angeordnet sein und unterschiedliche Durchmesser aufweisen. Die Perforation kann auch versetzt angeordnet sein, um eine größere Lochdichte zu erhalten. Geometrisch vorteilhaft kann auch eine hexagonale Wabenstruktur sein.

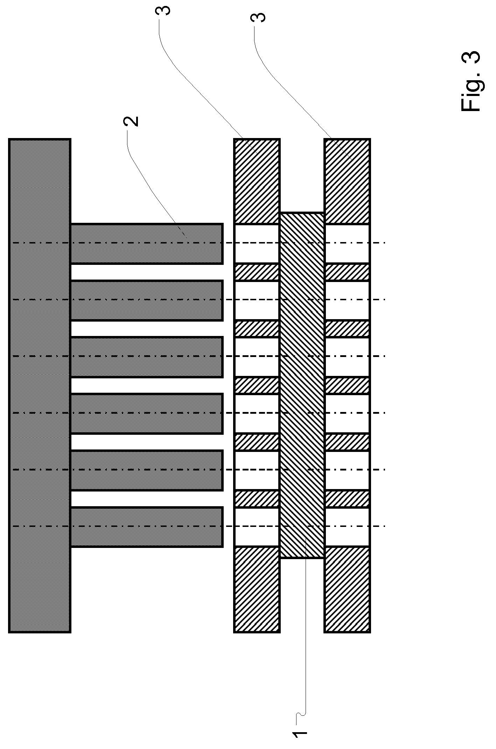

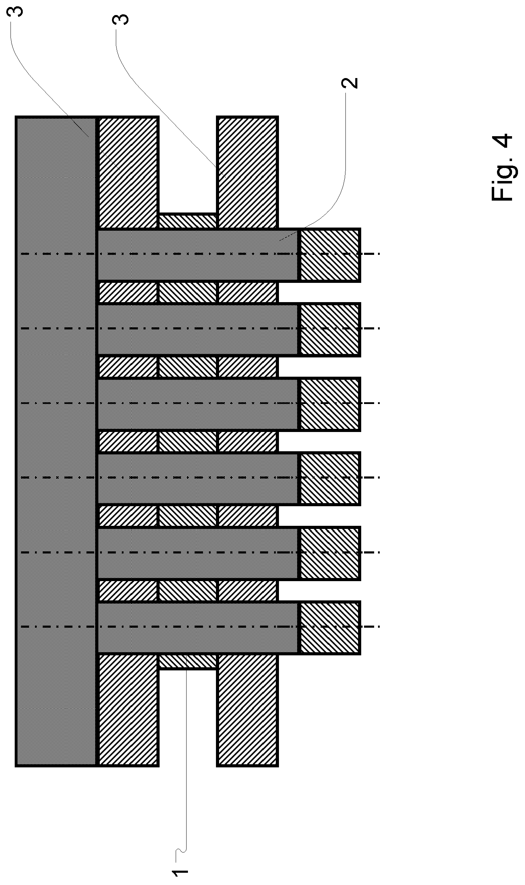

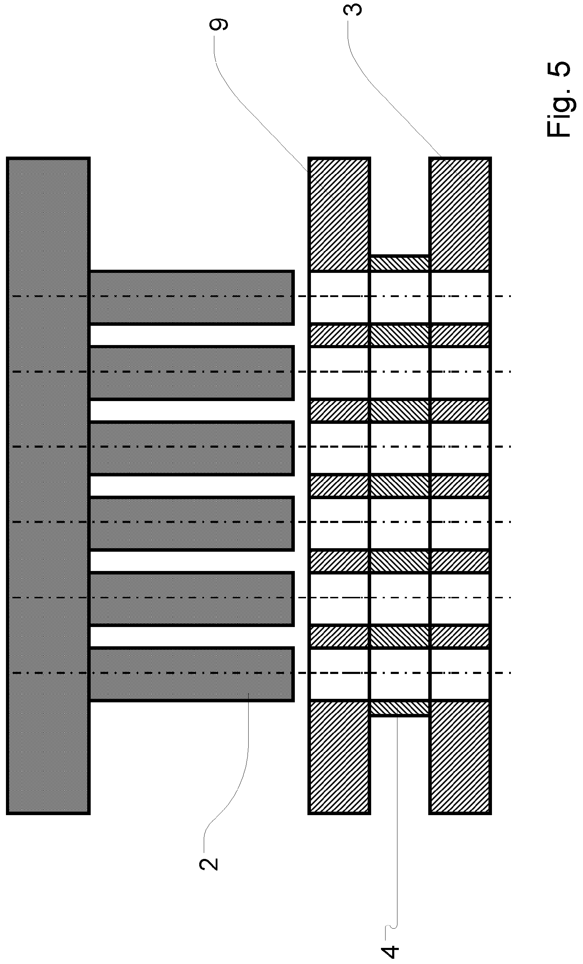

In den Figuren 3, 4 und 5 ist das Herstellen der Matrize 4 noch einmal deutlicher dargestellt. Hierzu wird eine zunächst ungelochte Platte 1 aus dem gewählten Matrizenmaterial zwischen zwei gelochten Masken 3 eingespannt. Die Masken 3 sind aus einem Metallwerkstoff gefertigt und weisen das gewünschte Lochmuster der Matrize auf. Ein mit dem gewünschten Lochmuster korrespondierendes, schneidendes Lochwerkzeug 2 aus Metall oder Hartmetall fährt in die obere Maske 3 ein und locht an den Lochkanten der unteren Maske 3 die Platte 1, sodass eine in dem Lochmuster perforierte Matrize 4 entsteht (Figur 4). Das Lochwerkzeug 2 wird danach herausgefahren (Figur 5).

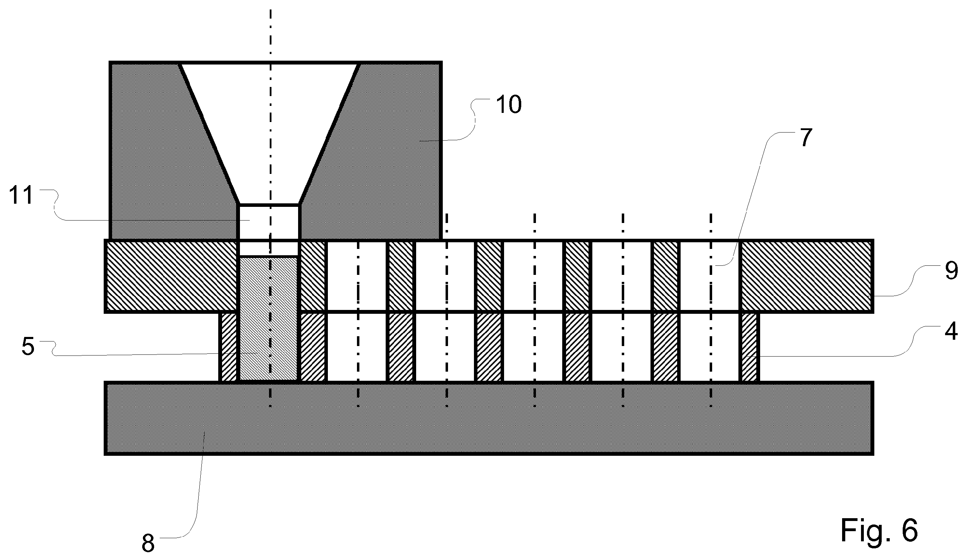

Gemäß Figur 6 wird sodann Matrize 4 auf eine ebene Bahn 8 aufgelegt, welche die Löcher 7 nach unten verschließt. An die Stelle der oberen Maske wird ein mit einem korrespondierenden Lochmuster versehener Niederhalter 9 angeordnet, welcher die Matrize 4 gegen die Bahn 8 presst. Eine Probenvorlage 10 gefüllt mit Aktivmaterial 5 wird über den Löchern positioniert und ein Teil der Löcher 7 mit dem Aktivmaterial befüllt.

Während des Befüllens ist die gelochte Matrize 4 zwischen der unten angeordneten Bahn 8 und einem von oben herabgefahrenen Niederhalter 9 eingespannt. Sowohl bei der Bahn als auch bei dem Niederhalter 9 handelt es sich um ebene Metallplatten. Die Bahn ist nicht mit einer Perforation versehen, um die Löcher der Matrize 4 während des Befüllvorgangs zu verdecken. Der Niederhalter 9 ist indes mit geeigneten Löchern versehen, die eine Befüllung der Löcher der Matrize erlauben.

Zu diesem Zwecke wird eine Probenvorlage 10 gefüllt mit pulverförmigem, trockenem Aktivmaterial über den jeweils zu befüllenden Löchern der Matrize 4 positioniert. Zu diesem Zwecke weist die Probenvorlage 10 ein Rohr 11 auf, welches sich während des Befüllvorgangs im Wesentlichen koaxial zu dem zu befüllenden Loch 7 der Matrize erstreckt. Der Querschnitt des Rohres 11 entspricht im Wesentlichen dem Querschnitt des zu befüllenden Loches 7. Während des Befüllens wird eine Pulvermenge in das Loch 7 eingefüllt, so dass das Loch 7 komplett gefüllt ist. Ggf. kann sich die Pulvermenge auch in die koaxial korrespondierende Öffnung in dem Niederhalter 9 erstrecken, um Schwund und die Volumenverringerung des Pulvers bei der Verdichtung des Pressvorgangs auszugleichen. Bahn 8 und Niederhalter 9 werden über eine nicht dargestellte Verschraubung (oder hydraulisch/pneumatisch/magnetisch) gegeneinander verspannt.

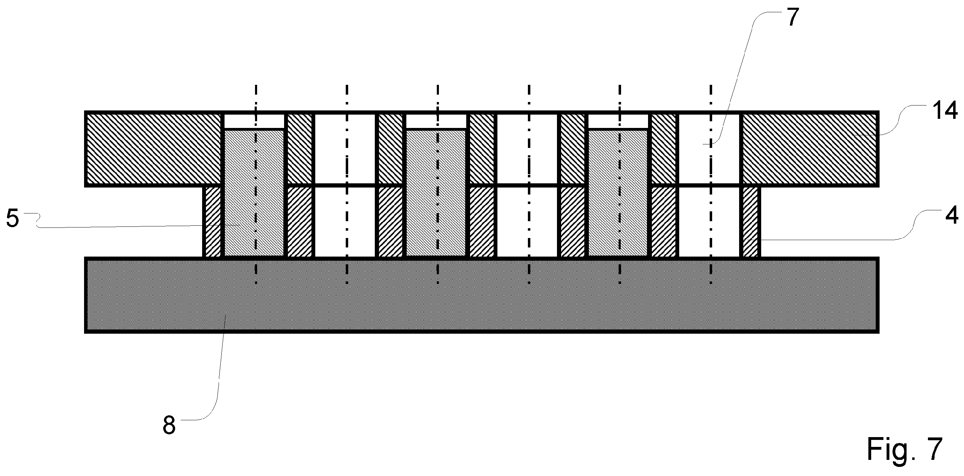

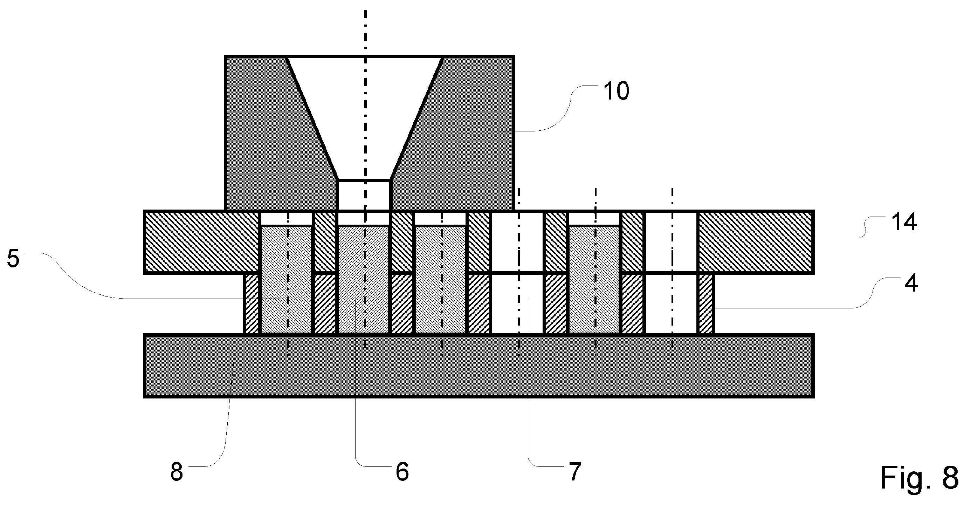

Nachdem die Hälfte der Löcher mit Aktivmaterial einer ersten Sorte 5 befüllt sind (Figur 7) werden die verbleibenden Löcher 7 mit einer zweiten Sorte Aktivmaterial 6 gefüllt (Figur 8), sodass die Matrize 4 alternierend mit den beiden Aktivmaterialen 5, 6 gefüllt ist (Figur 9).

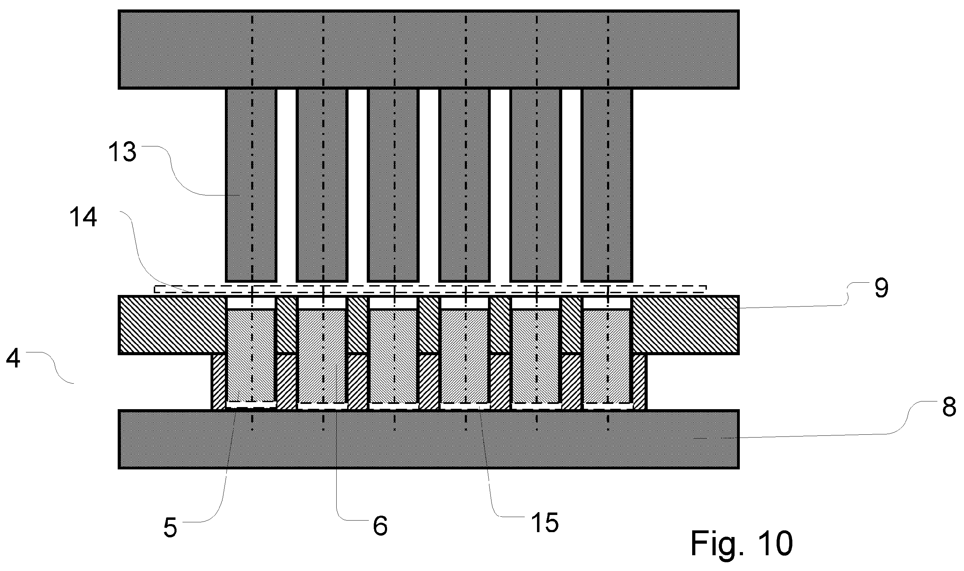

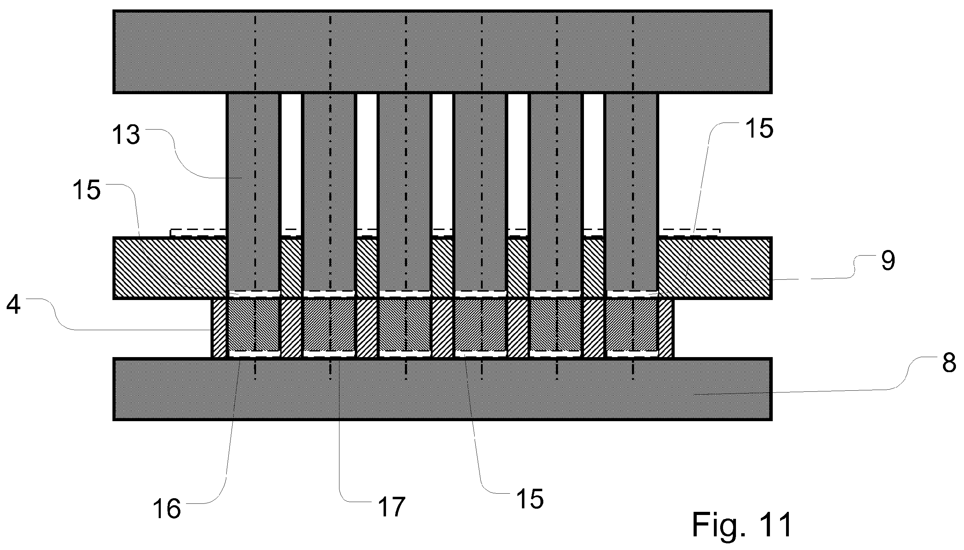

In dem in den Figuren 10 und 11 dargestellten nächsten Arbeitsschritt fährt ein Stempel 13, dessen Querschnitt wiederum dem Querschnitt des zu verpressenden Loches 7 entspricht, durch den Niederhalter 9 hernieder und verpresst das Aktivmaterial in dem Loch 7 zu Grünlingen 16, 17. Die beim Niederfahren des Stempels 13 wirkenden Presskräfte werden vom Niederhalter 9 und der Bahn 8 aufgefangen. Auf Grund der erfindungsgemäß gewählten Partikelgrößenverteilung verhält sich das Pulver noch nicht fluidisch, sodass die von dem Stempel 13 ausgeübten Presskräfte nur zu einem geringen Teil in Querkräfte umgesetzt werden, welche die Löcher 7 radial weiten und die Matrize 4 sprengen könnten.

Sofern eine Barriereschicht auf das Aktivmaterial aufgebracht werden muss, um einen Kontakt des Aktivmaterials mit dem Lot zu verhindern, bietet es sich an, die Barriereschicht direkt aus einer Folie 14 zu pressen: Hierfür wird die Folie 14 beispielsweise aus Nickel auf den Niederhalter 9 aufgelegt (Figur 10). Der Niederhalter 9 wirkt dann beim Niederfahren des Stempels 13 wie ein Gesenk: An der Schneidkante zwischen Stempel 13 und Niederhalter 9 wird aus der Folie 14 je eine Scheibe 15 ausgeschnitten und diese durch den Niederhalter nach unten auf das Aktivmaterial gepresst. Die Scheiben 15 verdecken dann das Pulver und schützen die späteren Thermoschenkel vor schädigenden Einflüssen.

In an sich analoger Weise können Scheiben 15 aus Barrierefolie zusätzlich bereits vor der Befüllung der Löcher 7 mit Aktivmaterial 5, 6 durch Ausstanzen in diese Löcher hineinpräpariert werden, d.h. zwischen den in Figuren 5 und 6 gezeigten Arbeitsschritten (nicht dargestellt). Somit werden dann am Ende des Pressvorganges analog Figur 11 Thermoschenkel-Grünlinge 16, 17 erhalten, welche auf beiden Stirnseiten mit Scheiben 15 aus Barrierematerial abgedeckt sind.

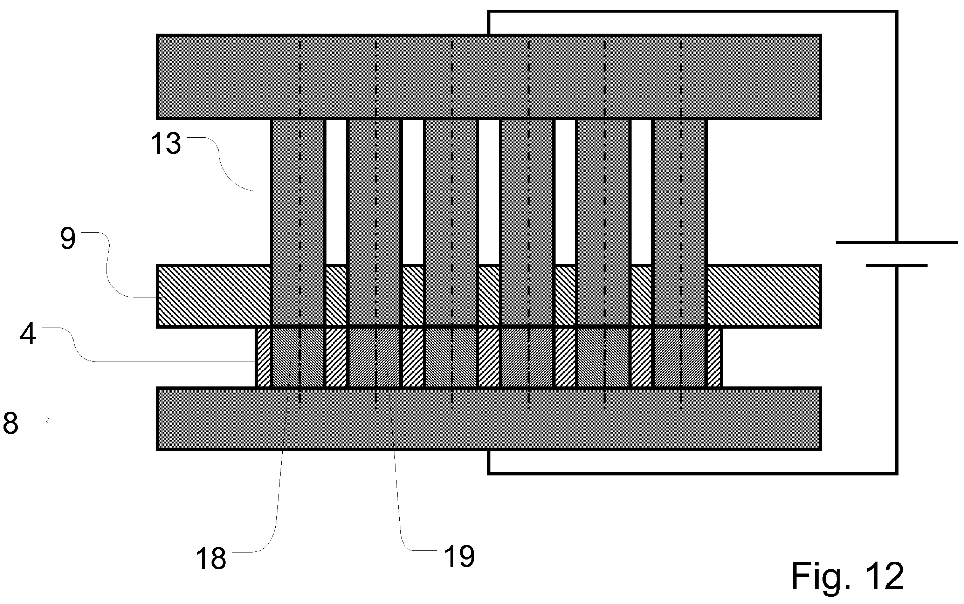

Um aus den Grünlingen 16, 17 Thermoschenkel 18, 19 zu sintern, wird der Stempel 13 mit einem elektrischen Strom beaufschlagt (Figur 12). Die Sinterung erfolgt aufgrund des elektrischen Stromes, der durch den verdichtenden Stempel 13, der nun als Elektrode wirkt, durch die Grünlinge 16, 17 hindurch zur Bahn 8 fließt, wobei gegebenenfalls auch noch ein gewisser Pressdruck über den Stempel 13 auf die Grünlinge 16, 17 übertragen wird. Elektrische Spannung, Stromstärke und mechanischer Druck können über die Zeit variiert werden, siehe Beispiel.

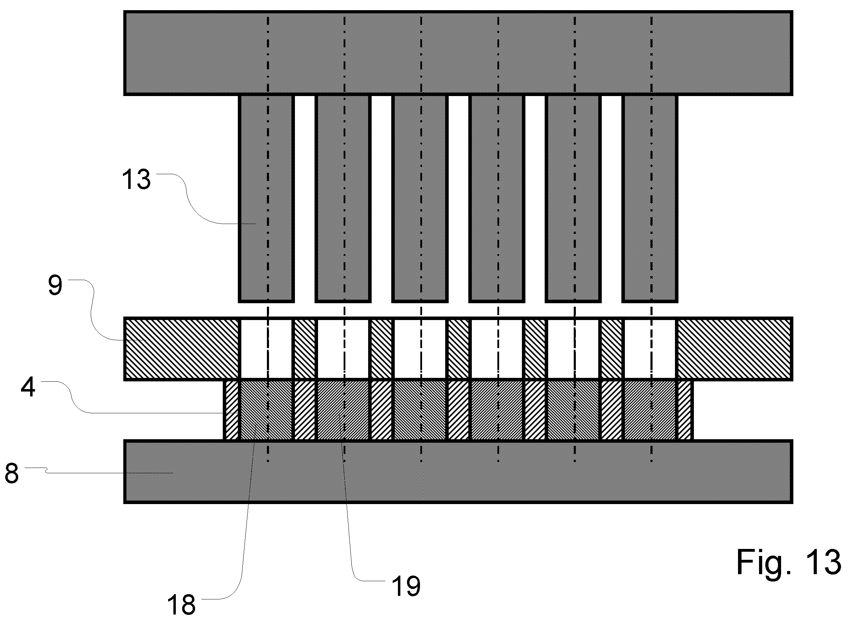

Nach Abschluss des Sinterprozesses wird der Stempel 13 entfernt, sodass ein Halbzeug (Matrize 4 mit eingefüllten Thermoschenken 18, 19) zurück bleibt; vgl. Figuren 13 und 14.

Die Thermoschenkel sind dann noch in geeigneter Weise elektrisch zu verbinden, etwa durch Auftragen von Lot. Sofern eine Barriereschicht aufgetragen wurde, trennt die Barriereschicht das Lot vom Aktivmaterial. Auf diese Weise erhält man ein thermoelektrisches Bauelement.

### Beispiel 1

Es werden die n- bzw- p-leitenden Aktivmaterialien (z.B. auf Basis von Wismuttellurid gemäß der in Tabelle 1 dargestellten atomaren Zusammensetzung) in einer Glovebox unter Stickstoffatmosphäre (5.0) in einen Zirkonoxid-Mahlbecher eingebracht, nebst Zirkonoxid-Mahlkugeln. Der Mahlbecher wird sodann in eine Planetenmühle (Fritsch Planeten-Monomühle "Pulverisette 6" classic line) eingespannt und bei 650 Umdrehungen pro Minute 10 mal für je 15 Minuten vermahlen, mit dazwischen liegenden Pausen aus Zwecken der Kühlung (Überhitzung des Mahlgutes vermeiden). Danach wird die Partigelgrößenverteilung mittels eines HORIBA 950-L bestimmt (Partikelprobe in demineralsiertem Wasser mittels Ultraschall dispergiert). Sofern der d₅₀-Wert unterhalb 8µm liegt ist die Mahlung abgeschlossen, ansonsten werden nach Bedarf weitere Mahldurchgänge mit genannten Einstellungen durchgeführt, bis der gewünschte d₅₀-Wert erreicht bzw. unterschritten ist. Die gemahlenen Aktivmaterial - Pulver verbleiben bis zur weiteren Verwendung unter Stickstoff gelagert.

**Tabelle 1: atomare Zusammensetzung der verwendeten Aktivmaterialien gemäß Semi-RFA (Röntgenfluoreszenzanalyse)**

| **Elemente** | **p-Typ / wt%** | **n-Typ / wt%** |
|---|---|---|
| SumBe..Fe | 0.24 | - |
| 34+Se | 4.01 | 2.56 |
| 51+Sb | - | 1.11 |
| 52+Te | 41.61 | 43.5 |
| SumLa..Lu | 0.21 | 0.34 |
| 83+Bi | 54.29 | 52.8 |

In eine 2mm dicke Platte aus massivem PPSU werden zylindrische 4mm-Bohrungen gebohrt. Diese Platte dient als Substrat. Über das Substrat wird eine Stempelführung aus Metall gelegt (Dicke 10 mm), welche an den gleichen Stellen 4 mm-Bohrungen aufweist wie das Substrat, so dass die Bohrungen in Substrat und Stempelführung deckungsgleich übereinander liegen. Unter diese Anordnung kommt eine massive Metallplatte als Bahn. Die drei Lagen werden übereinander mittels Schrauben oder Zwingen fixiert, so dass ein Verschieben gegeneinander vermieden wird.

Nun werden pro Bohrung 0.2 +/- 0.025 g Aktivmaterial in die Löcher der Matrize eingefüllt und sichergestellt dass das Pulver bis auf den Boden, d.h. bis in die Löcher des Substrates hineinfällt. Durch abwechselndes Befüllen mit n- bzw. p-Halbleitermaterial wird eine geeignete Anordnung für den späteren thermoelektrischen Generator hergestellt.

Die derart befüllte Anordnung wird auf dem Untertisch einer Druckprüfanlage (z.B. Bauart ZWICK) fixiert. Der bewegliche Stempel der Druckprüfanlage verfügt über einen Stempel mit 4mm Außendurchmesser und plangeschliffener Unterseite. Dieser Stempel wird nun sukzessive in jede der Bohrungen der Stempelführung eingeführt und zum Verpressen der Pulverfüllung verwendet. Dazu wird der Stempel jeweils mit einer Vorschubgeschwindigkeit von 1 mm pro Minute bewegt, bis eine Gegenkraft von mindestens 1 kN pro Thermoschenkel (dies entspricht einem Druck von mindestens 800bar) erreicht ist. Diese Kraft wird nun für mindestens 10 Sekunden, besser 60 Sekunden gehalten. Danach wird der Stempel aus der Stempelführung herausgezogen und dieser Vorgang wird entsprechend bei allen befüllten Löchern identisch durchgeführt.

Danach wird das mit Halbleiter-Presslingen befüllte Substrat aus der Pressvorrichtung entfernt und die sichtbaren Stirnseiten der Presslinge werden mittels feinem Schleifpapier (200er Körnung) leicht poliert, danach gründlich mittels Druckluftpistole von Staub befreit.

Die Presslinge werden sodann unmittelbar anschließend einem Gleichstrom-Sintervorgang unterzogen. Dazu wird das Substrat auf eine Kontaktplatte aufgelegt, welche aus Kunststoff mit einem daraus hervorstehenden gefederten plangeschliffenen Nickelstift von 4mm Durchmesser besteht. Der zu sinternde Pressling wird genau über dem Kontaktstift positioniert, die Andruckfeder stellt einen guten flächigen Kontakt sicher. Von der Oberseite wird mittels Druckprüfvorrichtung ein zum erstgenannten identischer Nickelstift mit einer Anpresskraft von 500 Newton deckungsgleich auf den zu sinternden Pressling positioniert. Nun wird ein Gleichstrom angelegt, sodass die Temperatur auf 300°C steigt. Diese Temperatur wird für mindestens 5min, maximal 30 Minuten konstant gehalten. Hierdurch versintert der Pressling derart, dass nach dieser Prozedur ein spezifischer Widerstand von maximal 0.00001 Ohmmeter gemessen wird.

### Beispiel 2:

In ansonsten analoger Weise zum Beispiel 1 wird die Einpressung des pulverförmigen Halbleitermaterials bei einem Pressdruck von nur noch 5*10⁷ Pa (500bar) vorgenommen. Trotz des geringeren Einpressdruckes wird annähernd die gleiche Zieldichte des Thermoschenkels erzielt, bei gleichzeitig deutlich verringerter Wahrscheinlichkeit der Ausbildung von Gefügestörungen (Risse, Verwerfungen, Aufdeckelungen), dank geringerer Kräfte auf die Flanken der Bohrung im Substrat geringere seitliche Ausdehnung des Thermoschenkels, sowie weitgehend gleichbleibender elektrischer und thermoelektrischer Eigenschaften. Somit wird eine deutlich geringere Ausschußquote an Thermoschenkeln erzielt. Weiterhin werden Verformungen am Substrat, die unter Umständen Nachbearbeitungen notwendig machen, weitgehend vermieden.

## Patentansprüche

1. Verfahren zur Herstellung eines thermoelektrischen Bauelements oder zumindest eines Halbzeugs desselben, bei welchem zumindest ein thermoelektrisches Aktivmaterial in trockener Pulverform in zumindest einen Teil der Löcher einer perforierten Matrize eingebracht wird, **dadurch gekennzeichnet, dass** das Aktivmaterial in den Löchern verbleibt und dass die mit Aktivmaterial gefüllte Matrize zu einem Bestandteil des hergestellten thermoelektrischen Bauelements wird.

2. Verfahren nach Anspruch 1,
**dadurch gekennzeichnet,**
**dass** zwei unterschiedliche thermoelektrische Aktivmaterialien mit zwei unterschiedlichen Seebeck-Koeffizienten eingesetzt werden, wobei in einem ersten Verfahrensabschnitt das erste thermoelektrische Aktivmaterial in einen ersten Teil der Löcher eingepresst wird, und dass in einem zweiten Verfahrensabschnitt das zweite thermoelektrische Aktivmaterial in einen zweiten Teil der Löcher eingepresst wird.

3. Verfahren nach Anspruch 1 oder 2,
**dadurch gekennzeichnet,**
**dass** es sich bei dem Aktivmaterial um Wismuthtellurid handelt, und dass die mittels Laserbeugungsverfahren bestimmte Partikelgrößenverteilung des Aktivmaterials eine mittlere Partikelgröße d₅₀ zwischen 1 und 100 µm, bevorzugt zwischen 2 und 10 µm und ganz besonders bevorzugt zwischen 3 und 5 µm aufweist.

4. Verfahren nach Anspruch 1, 2 oder 3,
**dadurch gekennzeichnet,**
**dass** die Matrize aus einem thermisch und elektrisch isolierenden Werkstoff besteht.

5. Verfahren nach Anspruch 4,
**dadurch gekennzeichnet,**
**dass** die Matrize aus einem nicht metallischen Werkstoff besteht, insbesondere ausgewählt aus der Gruppe umfassend Polyetheretherketon (PEEK), Polytetrafluorethylen (PTFE), Polyphenylsulfon (PPSU), Polyphenylensulfid (PPS), pyrogene Kieselsäure, gefällte Kieselsäure, Metalloxide, Polyimid.

6. Verfahren nach Anspruch 4,
**dadurch gekennzeichnet,**
**dass** die Matrize aus einem Verbundwerkstoff aus anorganischen Rohstoffen und Bindemitteln besteht, wobei es sich bei dem Bindemittel insbesondere um Silikon oder Silikonharz handelt, und wobei die anorganischen Rohstoffen insbesondere ausgewählt sind aus der Gruppe umfassend Glimmer, Perlite, Phlogopite, Muscovite.

7. Verfahren nach einem der vorhergehenden Ansprüche,
**dadurch gekennzeichnet,**
**dass** die Stärke der Matrize 0.1 bis 10 mm, vorzugsweise 0.5 bis 5 mm, ganz besonders bevorzugt 1 bis 3 mm beträgt.

8. Verfahren nach einem der vorhergehenden Ansprüche,
**dadurch gekennzeichnet,**
**dass** sich die Löcher im Wesentlichen parallel zur Flächennormalen der Matrize erstrecken.

9. Verfahren nach einem der vorhergehenden Ansprüche,
**dadurch gekennzeichnet,**
**dass** die Löcher einen kreisrunden oder einen elliptischen oder einen polygonalen, insbesondere hexagonalen Querschnitt aufweisen.

10. Verfahren nach einem der vorhergehenden Ansprüche,
**dadurch gekennzeichnet,**
**dass** das Verhältnis des Äquivalentdurchmessers der Löcher zur Stärke der Matrize 0.1 bis 10, insbesondere 0.5 bis 5 und ganz besonders bevorzugt 1 bis 2 beträgt.

11. Verfahren nach einem der vorhergehenden Ansprüche,
**dadurch gekennzeichnet,**
**dass** es in inerter und/oder reduzierender Atmosphäre durchgeführt wird.

12. Verfahren nach Anspruch 11,
**dadurch gekennzeichnet,**
**dass** es in einer Atmosphäre enthaltend 95 bis 99.5 Vol.-% N₂ und 0.5 bis 5 Vol.-% H₂ durchgeführt wird.

13. Verfahren nach einem der vorhergehenden Ansprüche,
**dadurch gekennzeichnet,**
**dass** die Matrize während des Einpressens des Aktivmaterials von einer Bahn gestützt wird, welche zumindest die momentan mit Aktivmaterial zu verpressenden Löcher endseitig abdeckt.

14. Verfahren nach Anspruch 13,
**dadurch gekennzeichnet,**
**dass** die Matrize während des Einpressens des Aktivmaterials von einem Niederhalter gegen die Bahn gedrückt wird, dergestalt, dass die Matrize zwischen Niederhalter und Bahn gehalten wird.

15. Verfahren nach einem der vorhergehenden Ansprüche,
**dadurch gekennzeichnet,**
**dass** in einem ersten Schritt Aktivmaterial aus einem sich koaxial zu dem zu befüllenden Loch erstreckenden Rohr in das zu befüllende Loch eingefüllt wird, und dass in einem zweiten Schritt das in das Loch eingefüllte Aktivmaterial mit einem sich koaxial zu dem befüllten Loch erstreckenden Stempel verpresst wird.

16. Verfahren nach Anspruch 15,
**dadurch gekennzeichnet,**
**dass** die Querschnittsfläche des Rohrs und/oder die Querschnittsfläche des Stempels im Wesentlichen der Querschnittsfläche des Loches entspricht.

17. Verfahren nach einem der vorhergehenden Ansprüche,
**dadurch gekennzeichnet,**
**dass** das in den Löchern verpresste Aktivmaterial einem Sinterprozess unterworfen wird und dass die in den Löchern versinterten Aktivmaterialien zumindest auf einer Seite der Matrize untereinander elektrisch kontaktiert werden.

18. Verfahren nach Anspruch 17,
**dadurch gekennzeichnet,**
**dass** das in den Löchern verpresste Aktivmaterial mittels Strom-Sintern zu Thermoschenkel verfestigt werden.

19. Verfahren nach einem der vorhergehenden Ansprüche, bei dem auf die Aktivmaterialen eine Diffusionsbarriere und optional darauf eine Kontaktschicht aufgebracht wird.

20. Verfahren nach einem der Ansprüche 15 bis 19,
**dadurch gekennzeichnet,**
**dass** auf die Matrize ein Gesenk und auf diesem eine Folie aus Barrierematerial, insbesondere aus Nickel aufgelegt wird, und dass mittels des Stempels an der Schneidkante des Gesenks eine Scheibe aus der Folie ausgestanzt wird und diese als Barriereschicht auf das Aktivmaterial aufgepresst wird.

21. Verfahren nach einem der vorhergehenden Ansprüche,
**dadurch gekennzeichnet,**
**dass** das Aktivmaterial zusammen mit zumindest einem pulverförmigen Additiv verpresst wird.

## Claims

1. Method for producing a thermoelectric component or at least one semifinished version thereof, in which at least one thermoelectric active material in dry powder form is introduced into at least some of the holes of a perforated template, **characterized in that** the active material remains in the holes and the template filled with active material becomes a constituent of the thermoelectric component produced.

2. Method according to Claim 1,
**characterized in that**
two different thermoelectric active materials having two different Seebeck coefficients are used, the first thermoelectric active material being injected into a first portion of the holes in a first part of the method and the second thermoelectric active material being injected into a second portion of the holes in a second part of the method.

3. Method according to Claim 1 or 2,
**characterized in that**
the active material is bismuth telluride, and the particle size distribution of the active material determined by means of laser diffraction methods has a median particle size d₅₀ between 1 and 100 µm, preferably between 2 and 10 µm and most preferably between 3 and 5 µm.

4. Method according to Claim 1, 2 or 3,
**characterized in that**
the template consists of a thermally and electrically insulating material.

5. Method according to Claim 4,
**characterized in that**
the template consists of a nonmetallic material, especially selected from the group comprising polyether ether ketone (PEEK), polytetrafluoroethylene (PTFE), polyphenylsulphone (PPSU), polyphenylene sulphide (PPS), fumed silica, precipitated silica, metal oxides, polyimide.

6. Method according to Claim 4,
**characterized in that**
the template consists of a composite material composed of inorganic raw materials and binders, the binder being especially silicone or silicone resin, and the inorganic raw materials being especially selected from the group comprising mica, perlite, phlogopite, muscovite.

7. Method according to any of the preceding claims,
**characterized in that**
the thickness of the template is 0.1 to 10 mm, preferably 0.5 to 5 mm, most preferably 1 to 3 mm.

8. Method according to any of the preceding claims,
**characterized in that**
the holes extend essentially parallel to the surface normal of the template.

9. Method according to any of the preceding claims,
**characterized in that**
the holes have a circular or elliptical or polygonal, especially hexagonal, cross section.

10. Method according to any of the preceding claims,
**characterized in that**
the ratio of the equivalent diameter of the holes to the thickness of the template is 0.1 to 10, especially 0.5 to 5 and most preferably 1 to 2.

11. Method according to any of the preceding claims,
**characterized in that**
it is conducted in an inert and/or reducing atmosphere.

12. Method according to Claim 11,
**characterized in that**
it is conducted in an atmosphere comprising 95% to 99.5% by volume of N₂
and 0.5% to 5% by volume of H₂.

13. Method according to any of the preceding claims,
**characterized in that**
the template is supported during the injection of the active material by a backing sheet which covers the ends of at least the holes that are to be injected at that time with active material.

14. Method according to Claim 13,
**characterized in that**
the template is pressed against the backing sheet by a hold-down device during the injection of the active material, in such a way that the template is held between the hold-down device and backing sheet.

15. Method according to any of the preceding claims,
**characterized in that**
in a first step active material is introduced from a tube which extends coaxially with the hole to be filled into the hole to be filled, and in a second step the active material introduced into the hole is compressed with a ram which extends coaxially to the filled hole.

16. Method according to Claim 15,
**characterized in that**
the cross-sectional area of the tube and/or the cross-sectional area of the ram corresponds essentially to the cross-sectional area of the hole.

17. Method according to any of the preceding claims,
**characterized in that**
the active material compressed in the holes is subjected to a sintering operation and electrical contacts are formed between the active materials sintered in the holes at least on one side of the template.

18. Method according to Claim 17,
**characterized in that**
the active material compressed in the holes is compacted by means of current sintering to form thermolegs.

19. Method according to any of the preceding claims, in which a diffusion barrier is applied to the active materials and a contact layer is optionally applied to said diffusion barrier.

20. Method according to any of Claims 15 to 19,
**characterized in that**
a die is placed onto the template and a foil of barrier material, especially of nickel, is placed onto said die, and the ram is used to punch a disc out of the foil at the cutting edge of the die, and said disc is pressed onto the active material as barrier layer.

21. Method according to any of the preceding claims,
**characterized in that**
the active material is compressed together with at least one pulverulent additive.

## Revendications

1. Procédé de fabrication d'un composant thermoélectrique ou d'au moins un semi-produit de celui-ci, selon lequel au moins un matériau actif thermoélectrique sous forme de poudre sèche est introduit dans au moins une partie des trous d'une matrice perforée, **caractérisé en ce que** le matériau actif reste dans les trous et **en ce que** la matrice remplie avec le matériau actif devient un constituant du composant thermoélectrique fabriqué.

2. Procédé selon la revendication 1, **caractérisé en ce que** deux matériaux actifs thermoélectriques différents ayant deux coefficients de Seebeck différents sont utilisés, lors d'une première partie du procédé, le premier matériau actif thermoélectrique étant injecté dans une première partie des trous, et **en ce que**, lors d'une seconde partie du procédé, le second matériau actif thermoélectrique est injecté dans une seconde partie des trous.

3. Procédé selon la revendication 1 ou 2, **caractérisé en ce que** le matériau actif consiste en du tellurure de bismuth, et **en ce que** la distribution des tailles de particules du matériau actif déterminée par un procédé de diffraction laser présente une taille de particule moyenne d₅₀ comprise entre 1 et 100 µm, de préférence entre 2 et 10 µm, et de manière tout particulièrement préférée entre 3 et 5 µm.

4. Procédé selon la revendication 1, 2 ou 3, **caractérisé en ce que** la matrice est constituée d'un matériau thermiquement et électriquement isolant.

5. Procédé selon la revendication 4, **caractérisé en ce que** la matrice est constituée d'un matériau non métallique, notamment choisi dans le groupe comprenant la polyétheréthercétone (PEEK), le polytétrafluoroéthylène (PTFE), la polyphénylsulfone (PPSU), le polysulfure de phénylène (PPS), la silice pyrogène, la silice précipitée, les oxydes métalliques, le polyimide.

6. Procédé selon la revendication 4, **caractérisé en ce que** la matrice est constituée d'un matériau composite de matières premières inorganiques et de liants, le liant étant notamment une silicone ou une résine de silicone, et les matières premières inorganiques étant notamment choisies dans le groupe comprenant le mica, la perlite, la phlogopite, la muscovite.

7. Procédé selon l'une quelconque des revendications précédentes, **caractérisé en ce que** l'épaisseur de la matrice est de 0,1 à 10 mm, de préférence de 0,5 à 5 mm, de manière tout particulièrement préférée de 1 à 3 mm.

8. Procédé selon l'une quelconque des revendications précédentes, **caractérisé en ce que** les trous s'étendent essentiellement en parallèle à la normale de la matrice.

9. Procédé selon l'une quelconque des revendications précédentes, **caractérisé en ce que** les trous présentent une section circulaire ou elliptique ou polygonale, notamment hexagonale.

10. Procédé selon l'une quelconque des revendications précédentes, **caractérisé en ce que** rapport entre le diamètre équivalent des trous et l'épaisseur de la matrice est de 0,1 à 10, notamment de 0,5 à 5 et de manière tout particulièrement préférée de 1 à 2.

11. Procédé selon l'une quelconque des revendications précédentes, **caractérisé en ce qu'**il est réalisé dans une atmosphère inerte et/ou réductrice.

12. Procédé selon la revendication 11, **caractérisé en ce qu'**il est réalisé dans une atmosphère contenant 95 à 99,5 % en volume de N₂ et 0,5 à 5 % en volume d'H2.

13. Procédé selon l'une quelconque des revendications précédentes, **caractérisé en ce que** la matrice est supportée pendant l'injection du matériau actif par une bande, qui recouvre l'extrémité des trous dans lesquels le matériau actif est injecté momentanément.

14. Procédé selon la revendication 13, **caractérisé en ce que** la matrice est pressée contre la bande par un dispositif de maintien pendant l'injection du matériau actif, de sorte que la matrice soit maintenue entre le dispositif de maintien et la bande.

15. Procédé selon l'une quelconque des revendications précédentes, **caractérisé en ce que**, lors d'une première étape, le matériau actif est introduit dans le trou à remplir à partir d'un tube qui s'étend coaxialement par rapport au trou à remplir, et **en ce que**, lors d'une seconde étape, le matériau actif injecté dans le trou est pressé avec un poinçon qui s'étend coaxialement par rapport au trou rempli.

16. Procédé selon la revendication 15, **caractérisé en ce que** la surface de section du tube et/ou la surface de section du poinçon correspondent essentiellement à la surface de section du trou.

17. Procédé selon l'une quelconque des revendications précédentes, **caractérisé en ce que** le matériau actif injecté dans les trous est soumis à un procédé de frittage et **en ce que** les matériaux actifs frittés dans les trous sont en contact électrique les uns avec les autres au moins sur un côté de la matrice.

18. Procédé selon la revendication 17, **caractérisé en ce que** le matériau actif injecté dans les trous est solidifié par frittage par courant en une branche thermique.

19. Procédé selon l'une quelconque des revendications précédentes, selon lequel une barrière à la diffusion est appliquée sur les matériaux actifs, et éventuellement une couche de contact sur celle-ci.

20. Procédé selon l'une quelconque des revendications 15 à 19, **caractérisé en ce qu'**une étampe est placée sur la matrice et sur celle-ci un film en matériau de barrière, notamment en nickel, et **en ce qu'**au moyen du poinçon, un disque du film est découpé sur le côté coupant de l'étampe et celui-ci est pressé sur le matériau actif en tant que couche de barrière.

21. Procédé selon l'une quelconque des revendications précédentes, **caractérisé en ce que** le matériau actif est pressé conjointement avec au moins un additif en poudre.
